# EUROPEAN PATENT APPLICATION

(11) **EP 1 014 436 A2**
(43) Date of publication of application: **28.06.2000**
(21) Application number: 99310230.0
(22) Date of filing: 17.12.1999
(51) Int. Cl.: H01L 21/48

(54) **Process for producing a substrate**

(30) Priority: 24.12.1998 JP 36704098
(71) Applicant: SHINKO ELECTRIC INDUSTRIES CO. LTD., Nagano-shi, Nagano 380-0921 (JP)
(72) Inventor: Matsumoto, Syunichiro, Shinko Electric Industries, Nagano-shi, Nagano 380-0921 (JP); Emura, Hideki, Shinko Electric Industries, Nagano-shi, Nagano 380-0921 (JP); Ikeda, Hiroshi, Shinko Electric Industries, Nagano-shi, Nagano 380-0921 (JP); Miyasaka,Toshiji, Shinko Electric Industries, Nagano-shi, Nagano 380-0921 (JP)
(74) Representative: Rackham, Stephen Neil

(57) **Abstract**

A substrate for a semiconductor device (14) comprises a resinous board (44) having a cavity (16) for mounting a semiconductor element (14), conductor patterns (40) formed on an upper surface of the resinous board (44), second conductor patterns (42) formed on an inner layer or a second, opposite surface of the resinous board (44) and a conductor section (26) formed on an inner wall of the cavity (16) for electrically connecting the first conductor patterns (40) to the second conductor patterns (42). First, a metallic layer (48) is formed on the inner wall of the cavity (16) of the resinous board (44). Then, a masking layer (52) is formed. The masking layer (52) is composed of a metal insoluble in an etching liquid for etching the metallic layer (48), so as to cover the metallic layer (48). The masking layer (52) is partially removed by a mechanical means so that the masking layer (52) remains at positions where the conductor section (26) are to be formed. The metallic layer (48) is etched by applying the etching liquid so that the metallic layer (48) is removed at positions not covered by the masking layer (52). The masking layer (52) is etched by applying another etching liquid, which can dissolve the metal of the masking layer (52), but cannot dissolve the metallic layer (48), so that the masking layer (52) is removed and thus the conductor section (26) is formed on the inner wall of the cavity (16).

## Description

The present invention relates to a process for producing a substrate for a semiconductor device and, particularly, to a process for producing a substrate for a semiconductor device wherein conductor patterns are formed on one surface of a resinous board having a cavity for mounting a semiconductor element and other conductor patterns are formed on an inner layer and/or the other surface of the resinous board, and inside conductor sections are formed in an inner wall of the cavity of the resinous board, for electrically connecting the predetermined conductor patterns formed on the one surface of the resinous board to the predetermined conductor patterns formed on the inner layer and/or the other surface of the resinous board.

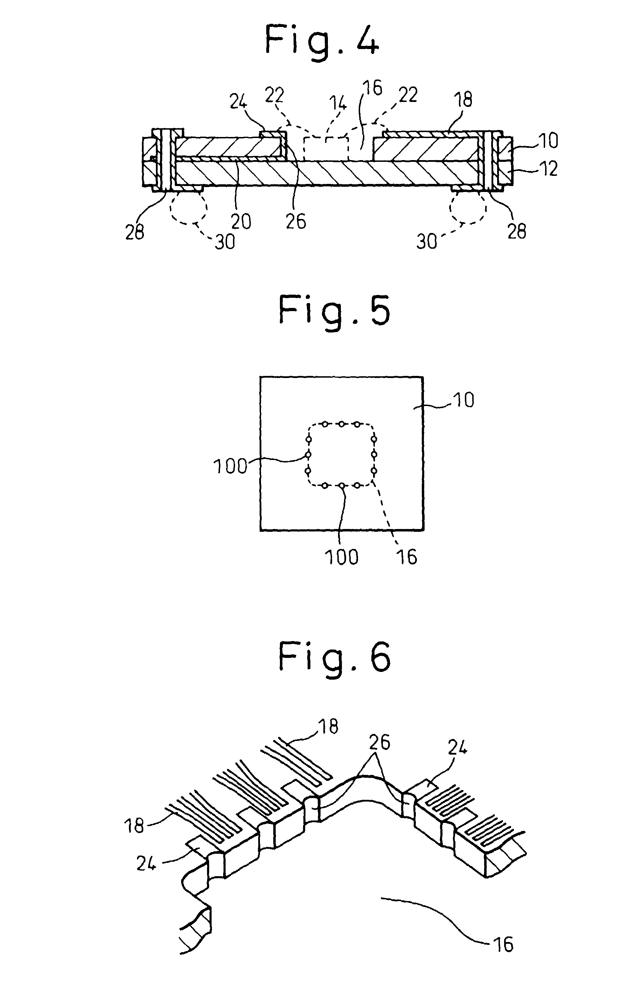

As shown in Fig. 4, there is a package for a semiconductor device wherein resinous boards 10 and 12 are laminated to each other. A semiconductor element 14 is mounted to the resinous board 12. A semiconductor element-mounting cavity 16 is formed in the other resinous board 10, for accommodating the semiconductor element 14 when the semiconductor element 14 is mounted to the resinous board 12. Conductor patterns 18 for signals are formed on the front surface of such a resinous board 10, and other patterns 20 are formed on the back surface of the resinous board 10 to be bonded to the resinous board 12. The other conductor patterns 20 may be used as a conductor pattern for a power source and/or a conductor pattern for a ground.

In such a manner, by forming the other patterns 20 used as a power source conductor pattern and/or a ground conductor pattern on the back surface of the resinous board 10, it is possible to densely form the signal conductor patterns 18 on the front surface of the resinous board 10.

Conductor patterns 24 to be bonded with one ends of wires 22 for electrically connecting the other conductor patterns 20 thereby with electrode terminals of the semiconductor element 14 mounted to the resinous board 12 are formed together with the signal conductor patterns 18 on one surface of the resinous board 10. The bonding conductor pattern 24 and the other conductor pattern 20 are connected to each other via an inside conductor section 26 formed in the inner wall of the cavity 16.

The bonding section of the signal conductor pattern 18 and the electrode terminal of the semiconductor element 14 are electrically connected to each other via the wire 22, and the signal conductor pattern 18 and the other conductor pattern 20 are electrically connected to external connector terminals 30, 30 via through-hole vias 28, 28 penetrated through the resinous boards 10, 12.

In this regard, it is difficult to form the inside conductor section 26 in the inner wall of the cavity 16 of the resinous board 10 by a photolithographic method using a photosensitive resist usually adopted for the formation of the signal conductor pattern 18 and the other conductor pattern 20. This is because it is extremely difficult to evenly irradiate light beams all over the inner wall of the cavity 16.

To obviate such inconveniences, a process is proposed, in Japanese Unexamined Patent Publication (Kokai) No. 7-86752, wherein, as shown in Fig. 5, after a plurality of through-holes 100 are bored through a resinous board 10 at a predetermined pitch along a contour of a cavity 16 to be formed in the board 10, a metallic layer is plated on the inner wall of the respective through-hole 100, and then an intermediate region between every adjacent two through-holes 100 is cut off by way of the through-holes 100 carrying the metallic layer in the inner wall thereof by means of a router or the like, thus obtaining the cavity 16.

According to the process described in the above-mentioned publication, inside conductor sections 26 of a semicircular cross-section are formed in the inner wall of the cavity. This process, however, has a drawback in that there is a risk of the generation of burrs in the inside conductor section 26 of a semicircular cross-section because the metallic layer formed in the inner wall of the through-hole 100 is mechanically cut by a router or the like. If the burrs are left as they are, they may be in contact with the adjacent inside conductor section 26 or the signal conductor pattern 18 to cause a short-circuit or other unfavorable situations.

An object of the present invention is to provide a process, for producing a substrate for a semiconductor device, capable of forming uniform inside conductor sections in the inner wall of a cavity, free from burrs, by means of a mechanical means such as a router.

The inventors have found through diligent study of the above problem that burrs generated in the metallic layer by the mechanical means, such as a router, are easily removable by etching, and reached the present invention.

Thus, according to the present invention, there is provided a process for producing a substrate for a semiconductor device, the substrate comprising a resinous board having a cavity for mounting a semiconductor element, first conductor patterns formed on a first surface of the resinous board, second conductor patterns formed on an inner layer or a second, opposite surface of the resinous board, a conductor section formed on an inner wall of the cavity for electrically connecting the first conductor patterns to the second conductor patterns,
the process comprising the following steps of: forming a metallic layer on the inner wall of the cavity of the resinous board; forming a masking layer, composed of a metal insoluble with a first etching liquid for etching the metallic layer, so as to cover the metallic layer; partially removing the masking layer by a mechanical means so that the masking layer remains at positions where the conductor section are to be formed; etching the metallic layer by applying the first etching liquid so that the metallic layer is removed at positions not covered by the masking layer; etching the masking layer by applying a second etching liquid, which can dissolve the metal of the masking layer, but cannot dissolve the metallic layer, so that the masking layer is removed and thus the conductor section is formed on the inner wall of the cavity.

The metallic layer is formed with a copper-plated layer and the masking layer is formed with tin or solder-plated layer.

The mechanical means for partially removing the masking layer comprising a rotating drill which is brought into contact with the inner wall of the cavity and moved along with the inner wall of the cavity.

The metallic layer can be formed all over a surface of the inner wall of the cavity of the resinous board, before the masking layer is formed.

According to the present invention, the patterning of the metallic layer formed to cover the entirety of the inner wall of the cavity of the resinous board and a masking layer covering the metallic layer, formed of a metal insoluble in an etching liquid for etching the metallic layer is carried out by mechanical stripping means for partially removing the masking layer, such as a router, and etching means for etching, with the above-mentioned etching liquid, the metallic layer from which the masking layer has been partially removed so that part of the surface of the metallic layer is exposed, after which the masking layer is dissolved and removed by an etching with another etching liquid capable of dissolving the metal forming the masking layer, thus obtaining the inside conductor sections. Thus, it is possible to easily remove the burrs or other defects generated in the respective layers due to the mechanical stripping means, during the etching operation applied on the masking layer and the metallic layer upon and after the patterning. As a result, a substrate for a semiconductor device is obtainable, wherein selected conductor patterns formed on one surface of the resinous board are connected to other selected conductor patterns formed on the inner layer and/or the other surface thereof via the uniform inside conductor sections formed in the inner wall of the cavity.

A particular embodiment in accordance with this invention will now be described with reference to the accompanying drawings; in which:-
Figs. 1(a) to 1(e) are sectional views, respectively, of the first half of a process for producing a substrate for a semiconductor device according to one embodiment of the present invention;
Figs. 2(a) to 2(e) are sectional views, respectively, of the latter half of the process for producing a substrate for a semiconductor device according to the above embodiment of the present invention;
Figs. 3(a) to 3(c) are front views, respectively, of the latter half of the process for producing a substrate for a semiconductor device according to the above embodiment of the present invention;
Fig. 4 is a sectional view of a package of a semiconductor device obtained by the process for producing a substrate for a semiconductor device according to the present invention;
Fig. 5 is an illustration of a prior art process for producing a resinous board for forming the package of a semiconductor device shown in Fig, 4; and
Fig. 6 is a broken perspective view of part of a substrate for a semiconductor device obtained by the prior art process.

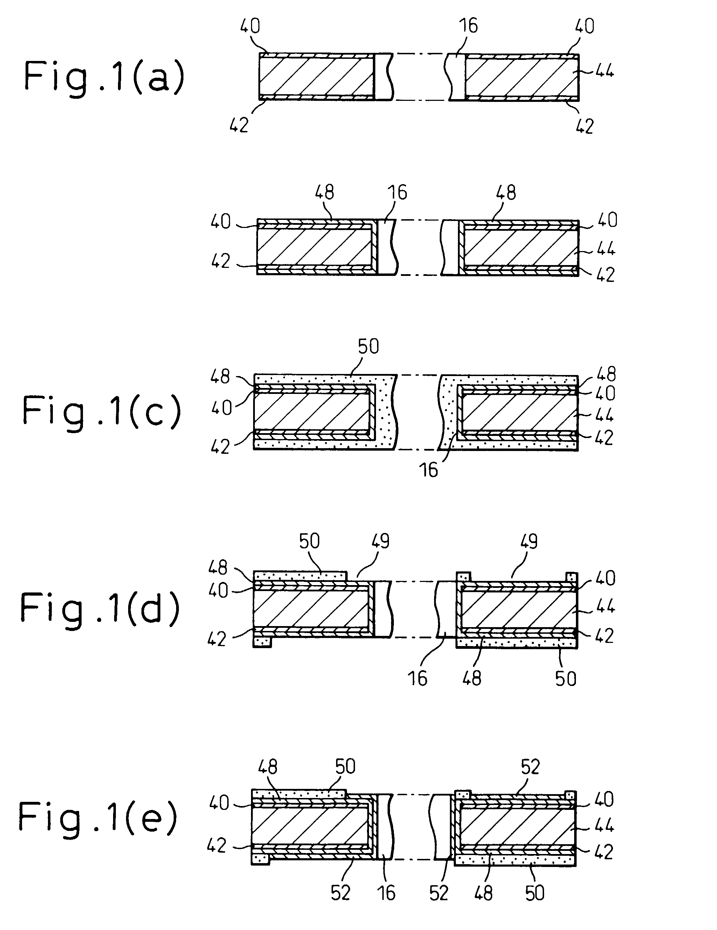

One embodiment of a production process according to the present invention will now be described with reference to Figs. 1(a) to 1(e), Figs. 2(a) to 2(e) and Figs. 3(a) to 3(c). First, as shown in Fig. 1(a), a cavity 16 is bored in a resinous board 44 carrying copper foils 40, 42 on opposite surfaces of a material formed of a glass-fiber cloth impregnated with resin. A copper layer 48 is formed all over the outer surfaces of the copper foils 40, 42 and the inner wall of the cavity 16 of the resinous board 44, as shown in Fig. 1(b). The copper layer 48 may be prepared by electroless plating and electro-plating. That is, the copper layer 48 is prepared by forming a thin layer of copper of approximately 1 µm thick all over the outer surfaces of the copper layers 40, 42 and the inner wall of the cavity 16 by electroless plating, after which a copper layer of 15 to 30 µm thick is formed by electro-plating while using this thin copper layer as a power-supply layer.

Then, the resinous board 44 is coated with a dry resist 50 which is a photosensitive resist so that the surface of the copper layer 48 is covered therewith as shown in Fig. 1(c). The dry resist 50 is also filled in the cavity 16, whereby the copper layer 48 formed in the inner wall of the cavity 16 is also covered with the dry resist 50.

Patternings for signal conductor patterns, other conductor patterns, bonding conductor patterns or the like are applied on both sides of the resinous board 44 with a dry resist 50 coated on the resinous board 44, as shown in Fig. 1(d). Among these patternings, the patternings for the signal conductor patterns and the bonding conductor patterns are applied to one side of the resinous board 44, while that for the other conductor patterns is applied to the other side of the resinous board 44.

These patternings are such that, by removing the dry resist 50 from portions 49 in which the conductor patterns are to be formed, a surface of a copper layer 48 is exposed. The patterning may be carried out by covering the dry resist 50 with a photo-mask carrying a configuration of a desired conductor pattern, exposing the masked resist to a light beam and developing the same. In a case shown in these drawings, the dry resist 50 is of a negative type wherein a portion exposed to light is left. This is because the dry resist 50 present on the inner surface of the cavity 16 is hardly exposed to the light beam and therefore is removed so that all the surface of the copper layer 48 formed on the inner surface of the cavity 16 appears outside.

Further, a masking layer 52 of tin (Sn) having a thickness in a range from 5 to 8 µm is formed on the portions 49 of the copper layer 48 exposed in conformity with the desired conductor pattern and the copper layer 48 on the inner surface of the cavity 16 by an electro-plating using the copper layer 48 as a power supply layer, as shown in Fig. 1(e). Tin (Sn) forming the masking layer 52 is insoluble in an acidic etching liquid containing ferric-chloride capable of etching the copper layer 48.

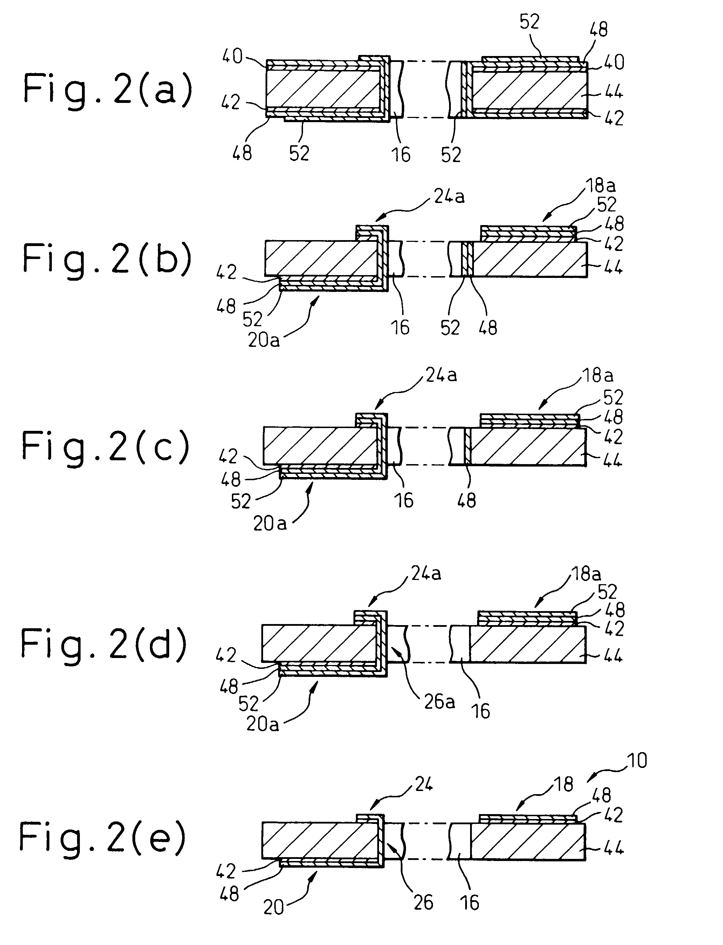

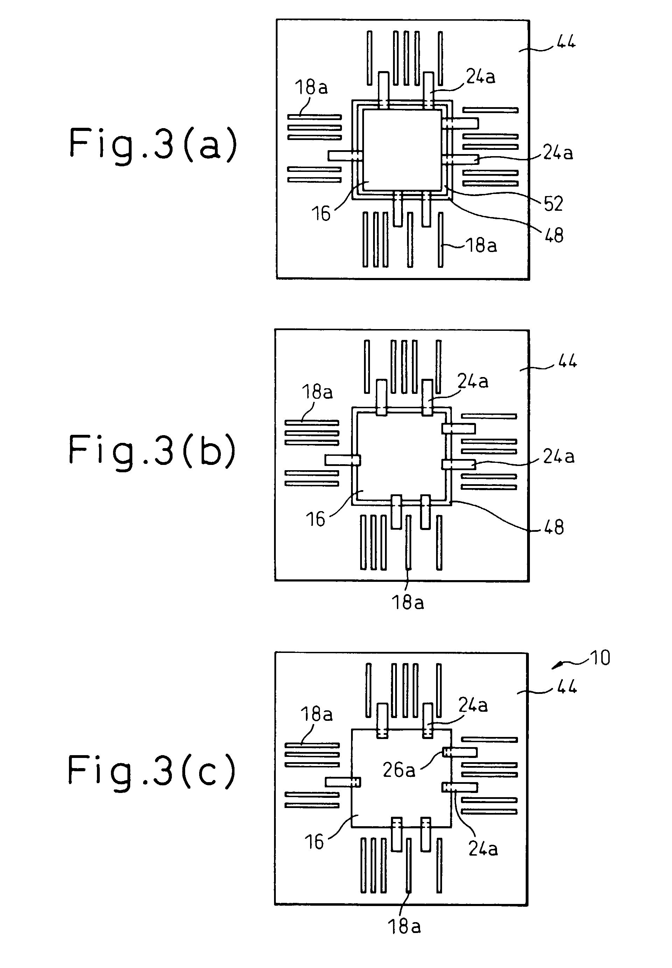

After the masking layer 52 is formed on the portions in which the desirably-shaped conductor pattern is formed in such a manner, the remaining dry resist 50 is removed, as shown in Fig. 2(a), and parts of the copper layer 48 and the copper foils 40, 42 exposed by the masking layer 52 are etched with an etching liquid capable of etching the copper layer 48 and removed, as shown in Fig. 2(b) and Fig. 3(a). By this etching operation, a conductor pattern portion 18a to be the signal conductor pattern 18 (which may be hereinafter referred merely to a "pattern 18"), another conductor pattern portion 20a to be the other conductor pattern 20 (which may be hereinafter referred merely to a "pattern 20a") and a bonding conductor pattern portion 24a to be the bonding conductor pattern 24 (which may be hereinafter referred merely to a "pattern 24a") are formed, as shown in Figs. 2(b) and Fig. 3(a).

Note each of the patterns 20a and each of the patterns 24a are electrically connected to each other by means of the copper layer 48 formed all over the inner surface of the cavity 16 and the masking layer 52 covering all over the copper layer 48.

Accordingly, in order to electrically connect predetermined patterns 20a to predetermined patterns 24a corresponding thereto, inner surface conductor sections 26 must be formed on the inner surface of the cavity 16. When the inner surface conductor sections 26 are formed, a patterning is applied to the portions of the masking layer 52 on which the inner surface conductor sections 26 are to be formed. To apply such a patterning, the masking layer 52 on the inner surface of the cavity 16 is partially removed by means of a mechanical means so that it remains in conformity with a shape of the inner surface conductor section 26, as shown in Fig. 2(c) and Fig. 3(b). The mechanical means used for this purpose may be a router wherein a drill having a cutting section at a tip end thereof is movable rightward and leftward as well as upward and downward while rotating. When such a router is used, it is possible to remove the masking layer 52 by moving the drill along the inner surface of the cavity 16 while keeping the circumference of the drill in contact with the masking layer 52. If the masking layer 52 is removed, a part of the copper layer 48 used as an underlayer of the masking layer 52 may also be removed.

In this regard, instead of moving the drill, the drill may be rotated at a predetermined position but the resinous board 44 may be moved to remove the masking layer 52.

Since a surface of the copper layer 48 appears out of the masking layer 52 in a region from which the masking layer 52 is removed, it is possible to remove the copper layer 48 by etching with an etching liquid incapable of etching the masking layer 52 but capable of dissolving the copper. As a result, the inner surface conductor pattern portion 26a to be the inner surface conductor section 26, (which may be hereinafter referred merely to as a "pattern 26a") for electrically connecting the pattern 20a with the pattern 24a is formed on the inner surface of the cavity 16, as shown in Figs. 2(d) and Fig. 3(c). During the etching operation, burrs generated when the masking layer 52 is partially removed by the mechanical means are also removable.

The masking layer 52 still left on the patterns 18a, 20a, 24a and 26a thus formed is removed by an etching operation, whereby a resinous board 10 is obtained wherein the bonding conductor patterns 24 formed on one side thereof are connected to the other conductor patterns 20 formed on the other side of the resinous board 10 by means of the inner surface conductor sections 26 formed on inner surface of the cavity 16 of the resinous board 10.

In the etching of the masking layer 52, an alkaline etching liquid capable of dissolving tin without dissolving copper such as sodium hydroxide can be used so that only the masking layer 52 is removed without etching the copper layer 48 forming the respective patterns.

During the etching of the masking layer 52, the burrs, which may be generated when the masking layer 52 is partially removed by the mechanical means, are also removed.

According to the process described with reference to Figs. 1(a) to 3(c), burrs or the like generated in the masking layer 52 and/or the copper layer 48 when the masking layer 52 is partially removed are completely eliminated by the two etching operations applied after the partial removal of the masking layer 52 by the mechanical means, resulting in smooth and even inner surface conductor sections 26.

With a substrate for a semiconductor device thus obtained, a package of a semiconductor device shown in Fig. 4 is obtainable.

In this regard, when the inner surface conductor sections 26 were formed by partially removing the copper layer 48 with a router, a burr generated in the copper layer 48 had an average height of 42.57 µm (standard deviation; 31.46 µm) as measured at 108 locations. On the other hand, when the inner surface conductor section 26 were formed by a process shown in Figs. 1(a) to 3(c), no such burrs were recognized.

Whilst the masking layer 52 is formed of tin (Sn) in the above-described embodiment, it may be formed of solder which also is insoluble in the etching liquid for etching the copper layer 48. The masking layer 52 of solder is also formed by electroplating.

Whilst the inner surface conductor section 26 in the above-mentioned embodiment is formed to have a width equal to that of the bonding conductor pattern 24, it may be much narrower than the pattern width of the bonding conductor pattern 24 provided it is electrically insulated from the adjacent inner surface conductor section 26.

In addition, the other conductor pattern 20 may be formed so as to have a width larger than that of the signal conductor pattern 18 so that it is usable as a power source conductor pattern or a ground conductor pattern. When the other conductor pattern 20 is used as a power source or ground conductor pattern, the copper layer 48 may be used as it is without applying patterning for etching thereon.

In the above description, while the conductor patterns formed on the opposite sides of the resinous board 10 are connected with each other via the inner surface conductor sections 26 formed on the inner surface of the cavity 16, it is also possible to apply the present invention to a multi-layer resinous board formed of a plurality of superposed resinous board components, each having conductor patterns. In other words, the electrical connection between conductor patterns formed in the inner layers of the multi-layer resinous board and those formed on one outer surface of the uppermost resinous board component is made via inner surface conductor sections formed on the inner surface of the cavity of the multi-layer resinous board. Also, it is possible to electrically connect the conductor patterns formed on one outer surface of the uppermost resinous board component with the conductor patterns formed in the inner layers of the multi-layer resinous board and conductor patterns formed on the other surface of the lowermost resinous board component via the inner surface conductor sections formed on the inner surface of the cavity of the multi-layer resinous board.

As mentioned above, according to the present invention, it is possible to easily form a smooth and even inner surface conductor sections free from burrs on the inner surface of a cavity, which conductor sections are difficult to form by a photolithographic method. As a result, a substrate for a semiconductor device is easily obtainable, wherein selected ones of conductor patterns formed on one side of a resinous board having a cavity are connected to other patterns formed on the other side of this resinous board via the inner surface conductor sections. Thereby, a substrate for a semiconductor device, carrying signal conductor patterns densely arranged on one side of the resinous board, is easily provided.

## Claims

1. A process for producing a substrate for a semiconductor device, said substrate comprising a resinous board (44) having a cavity (16) for mounting a semiconductor element (14), first conductor patterns (40) formed on a first surface of said resinous board (44), second conductor patterns (42) formed on an inner layer or a second, opposite surface of said resinous board, a conductor section (48) formed on an inner wall of said cavity (16) for electrically connecting said first conductor patterns (40) to said second conductor patterns (42), said process comprising the following steps of:
forming a metallic layer (48) on said inner wall of said cavity (16) of the resinous board (44) ;
forming a masking layer (52), composed of a metal insoluble in a first etching liquid for etching said metallic layer, so as to cover said metallic layer (48);
partially removing said masking layer (52) by a mechanical means so that said masking layer (52) remains at positions where said conductor sections are to be formed;
etching said metallic layer (48) by applying said first etching liquid so that said metallic layer (48) is removed at positions not covered by said masking layer (52);
etching said masking layer (52) by applying a second etching liquid, which can dissolve said metal of the masking layer (52), but cannot dissolve said metallic layer (48), so that said masking layer (52) is removed and thus said conductor section (48) is formed on the inner wall of said cavity (16).

2. A process according to claim 1, wherein said metallic layer (48) is formed with a copper-plated layer and said masking layer (52) is formed with tin or solder-plated layer.

3. A process according to claim 1 or 2, wherein said mechanical means for partially removing said masking layer (52) comprises a rotating drill which is brought into contact with said inner wall of the cavity (16) and moved along the inner wall of the cavity (16).

4. A process according to any one of the preceding claims, wherein said metallic layer (48) is formed on all over a surface of said inner wall of said cavity (16) of the resinous board (44) before said masking layer (52) is formed.
